# FASCICULE DE BREVET EUROPEEN

(11) **EP 4 090 928 B1**
(45) Date de publication et mention de la délivrance du brevet: **01.11.2023**
(21) Numéro de dépôt: 21700880.4
(22) Date de dépôt: 14.01.2021
(51) Int. Cl.: G01K 7/02, H01L 23/38, H01L 27/06, H01L 29/20, H01L 29/778, H10N 10/17

(54) **CAPTEUR THERMOÉLECTRIQUE À GAZ D'ÉLECTRONS**
THERMOELEKTRISCHER ELEKTRONEN-GAS-SENSOR
ELECTRON-GAS THERMOELECTRIC SENSOR

(30) Priorité: 16.01.2020 FR 2000402
(43) Date de publication de la demande: 23.11.2022
(73) Titulaire: Commissariat à l'Energie Atomique et aux Energies Alternatives, 75015 Paris (FR)
(72) Inventeur: SAVELLI, Guillaume, 38054 GRENOBLE CEDEX 09 (FR); BRYAN, Charlotte, 38054 GRENOBLE CEDEX 09 (FR); ESCOFFIER, René, 38054 GRENOBLE CEDEX 09 (FR); PLISSONNIER, Marc, 38054 GRENOBLE CEDEX 09 (FR)
(74) Mandataire: Cabinet Nony
(86) Numéro de dépôt international: PCT/EP2021/050734
(87) Numéro de publication internationale: WO 2021/144385

(56) Documents cités:
- US-B2- 8 872 302

## Description

La présente invention concerne un capteur thermoélectrique multicouche, notamment pour mesurer la température d'une unité électronique d'un composant électronique, par exemple un transistor de puissance. Elle concerne aussi un composant électronique comportant un transistor de puissance et tel un capteur thermoélectrique, ainsi qu'un procédé de fabrication du capteur thermoélectrique et du composant électronique de puissance.

Les unités électroniques constituant un composant électronique, notamment un composant électronique de puissance, peuvent s'échauffer lorsqu'elles sont alimentées électriquement. Un exemple d'une telle unité est un transistor de puissance, par exemple basé sur un matériau tel que le nitrure de gallium (GaN), l'arséniure de gallium (AsGa), ou le gallium-indium (InGa), qui s'échauffe sous l'effet de la puissance électrique qu'il génère. Il est donc utile de contrôler l'évolution de la température du transistor pour éviter une surchauffe du composant électronique qui le contient. A cette fin, le flux thermique et/ou la température du transistor peuvent être mesurés pour adapter la commande électrique du transistor en conséquence.

Actuellement, des résistances variables en fonction de la température, aussi appelées thermistance ou résistances « Tsense » sont mises en oeuvre pour mesurer la température de tels transistors. Elles sont par exemple:
- des thermistances métalliques intégrées à base de platine qui sont découplées de la zone active du composant;
- des thermistances à base de matériaux résistifs autres que le platine, par exemple en NiCr ou TaN, et
- des thermistances externes à base de platine, ou des diodes à base de silicium, qui sont disposés hors du composant électronique.

Ces thermistances nécessitent toutes d'être alimentées électriquement au moyen d'une source de courant. De plus, la mise en oeuvre de ces résistances nécessite une étape supplémentaire lors de la fabrication du circuit intégré.

Il est également connu dans l'état de la technique de former un élément de puissance et un élément de conversion thermoélectrique sur un substrat commun. Référence est faite à cet égard au brevet US8872302 B2.

Il existe donc un besoin pour mesurer simplement la température d'une unité électronique au sein d'un composant électronique, et de préférence sans complexifier la fabrication du composant électronique.

L'invention répond à ce besoin et propose un capteur thermoélectrique multicouche, pour générer un courant électrique sous l'effet d'un échauffement, le capteur thermoélectrique comportant un support et un couple thermoélectrique porté par le support et comportant :
- un premier organe thermoélectrique comportant au moins une portion d'un bicouche dont les couches sont en des matériaux différents, les couches du bicouche étant chacune non dopées, et
- un deuxième organe thermoélectrique comportant un matériau semi-conducteur dopé p et/ou un métal thermoélectrique,
le couple thermoélectrique étant configuré pour générer un gaz d'électrons à l'interface entre les couches du bicouche, lors de l'échauffement du capteur thermoélectrique.

Le bicouche, en générant un gaz d'électrons à l'interface entre les couches qui le constituent sous l'effet d'un échauffement, se comporte sensiblement comme un matériau thermoélectrique semi-conducteur dopé n.

Conformément à l'invention revendiquée, le capteur thermoélectrique est de fabrication aisée, ledit gaz d'électrons étant généré au moyen de matériaux semi-conducteurs non dopés. On peut ainsi s'affranchir d'une ou plusieurs étapes de dopage des couches du bicouche.

Par ailleurs, l'invention concerne un composant électronique comportant un capteur thermoélectrique selon l'invention et une unité électronique disposée sur le support, le composant électronique étant configuré pour que le capteur thermoélectrique génère un courant électrique sous l'effet de l'échauffement de l'unité électronique.

Ainsi, en mesurant le courant et/ou la tension électrique aux bornes du capteur thermoélectrique, l'échauffement et/ou la température de l'unité électronique peuvent être mesurés sans qu'aucune source de courant électrique ne soit nécessaire pour alimenter le capteur thermoélectrique.

L'invention concerne encore un dispositif choisi parmi un convertisseur d'énergie, un boitier de commande d'un moteur et un amplificateur de puissance hyperfréquence, le dispositif comportant un composant électronique selon l'invention.

Enfin, l'invention concerne un procédé de fabrication d'un capteur thermoélectrique selon l'invention, le procédé comportant les étapes successives suivantes de :
a) dépôt d'un premier matériau sur un substrat comportant le support, pour former la couche inférieure du bicouche et dépôt d'un deuxième matériau au contact de la couche inférieure pour former la couche supérieure du bicouche,
b) formation d'au moins une rainure traversant de part en part la couche supérieure dans l'épaisseur de la couche supérieure et s'étendant dans la couche inférieure,
   la portion du bicouche contigüe à la rainure et qui s'étend le long de la rainure définissant le premier organe thermoélectrique,
c) formation d'au moins un revêtement d'isolation électrique recouvrant en tout ou partie la ou les faces de la rainure,
d) formation d'au moins une couche d'insertion au moins en partie au contact avec le revêtement d'isolation électrique, et optionnellement dopage de type p de la couche d'insertion, pour former le deuxième organe thermoélectrique.

Le bicouche comporte une couche inférieure et une couche supérieure au contact l'une de l'autre. La couche inférieure est intercalée entre le support et la couche supérieure.

Selon l'invention, les couches du bicouche sont chacune non dopées. Ainsi, le premier organe thermoélectrique se comporte sensiblement comme un matériau thermoélectrique semi-conducteur dopé n, sans qu'aucun dopage des couches du bicouche ne soit nécessaire.

L'homme du métier sait déterminer des couples de matériaux pour former les couches inférieure et supérieure, qui sont aptes à générer un gaz d'électrons. A cette fin, par exemple :
- la couche inférieure est en SrTiO₃ et la couche supérieure est en LaAlO₃, ou
- la couche inférieure est en GaAs et la couche supérieure est en AlGaAs, ou
- la couche inférieure est en GaN et la couche supérieure est en AlGaN.

De préférence, le bicouche est constitué d'une couche en nitrure de gallium et d'une couche en nitrure d'aluminium-gallium.

De préférence, la couche inférieure est en nitrure de gallium et la couche supérieure est en nitrure d'aluminium-gallium.

La couche inférieure peut présenter une épaisseur comprise entre 1 µm et 5 µm, notamment entre 2 µm et 4 µm.

La couche supérieure peut présenter une épaisseur comprise entre 10 nm et 50 nm.

Par ailleurs, le premier organe thermoélectrique peut comporter une pellicule de piégeage d'électrons prise en sandwich entre les couches du bicouche et au contact de chacune des couches du bicouche.

La pellicule de piégeage d'électrons permet d'augmenter la quantité d'électrons du gaz d'électrons qui est piégée entre les énergies des bandes des matériaux constituant les couches du bicouche. De préférence, la pellicule de piégeage est en nitrure d'aluminium.

La pellicule de piégeage d'électrons est mince. Elle peut présenter une épaisseur qui est plus de dix inférieure à la moins épaisse des couches du bicouche. La pellicule de piégeage d'électrons peut présenter une épaisseur inférieure à 1 nm, par exemple d'environ 0,7 nm.

La pellicule de piégeage d'électrons peut être discontinue ou, de préférence, continue. Elle peut s'étendre sur toute l'interface entre les couches du bicouche.

Le deuxième organe thermoélectrique est en un matériau semi-conducteur dopé p ou en un métal thermoélectrique.

Le matériau thermoélectrique semi-conducteur dopé p est de préférence choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges, dopé p par un élément dopant, par exemple choisi parmi le zinc, le mercure, le cadmium, le magnésium et leurs mélanges. De préférence, le matériau thermoélectrique dopé p est le nitrure de gallium dopé p ou le nitrure d'aluminium-gallium dopé p.

De préférence, le deuxième organe thermoélectrique est en le métal thermoélectrique. On s'affranchit ainsi d'une étape de dopage du deuxième organe thermoélectrique au cours de la fabrication du capteur thermoélectrique.

Le métal thermoélectrique peut être choisi parmi le titane, l'or, l'aluminium, le platine et leurs alliages. Par exemple, le métal thermoélectrique est l'aluminium.

Par ailleurs, le capteur thermoélectrique peut comporter au moins une couche intercalée entre la couche inférieure et le support. En particulier, le capteur thermoélectrique peut comporter un empilement de capteur disposé sur et au contact du support et comportant consécutivement empilées les uns sur les autres :
- une couche de nitrure d'aluminium, par exemple d'épaisseur égale à 50 nm,
- la couche inférieure en nitrure de gallium, par exemple d'épaisseur comprise entre 2 µm et 4 µm, et
- la couche supérieure en nitrure d'aluminium-gallium, par exemple d'épaisseur comprise entre 10 nm et 40 nm.

De préférence, la couche supérieure, et optionnellement la couche inférieure, du bicouche et le deuxième organe thermoélectrique ont des première et deuxième régions non superposées l'une sur l'autre. Au moins la couche supérieure et le deuxième organe électrique peuvent ainsi être disposés côte à côte sur le capteur thermoélectrique.

Le deuxième organe thermoélectrique peut être superposé à la couche inférieure du bicouche.

De préférence, le deuxième organe thermoélectrique est logé au moins en partie dans une rainure ménagée dans le bicouche.

De préférence, la rainure traverse la couche supérieure de part en part selon l'épaisseur du bicouche, et s'étend dans la couche inférieure.

Dans un mode de réalisation, la rainure peut traverser le bicouche de part en part selon l'épaisseur du bicouche.

De préférence, la rainure s'étend longitudinalement et débouche sur deux bords opposés l'un à l'autre du bicouche. Ainsi, comme cela apparaîtra clairement par la suite, la rainure peut séparer la couche supérieure, voire le bicouche en deux parties distinctes. Les deux parties distinctes peuvent ainsi définir chacune deux premiers organes thermoélectriques isolés électriquement l'un de l'autre, qui peuvent être destinés à former des couples thermoélectriques différents.

La rainure peut s'étendre selon une direction curviligne ou, de préférence, rectiligne.

Par ailleurs, la rainure peut présenter une section en forme de « U », ou semi-circulaire. La profondeur de la rainure, mesurée entre la face sur laquelle débouche la rainure et le fond de la rainure, peut être compris entre 10 nm et 150 nm. Par exemple, elle est égale à 125 nm. La largeur de la rainure peut être comprise entre 1500 et 3000 nm et/ou la longueur de la rainure peut être comprise entre 0,5 mm et 2,0 mm, par exemple est égale à 1,0 mm.

Le deuxième organe thermoélectrique peut s'étendre sur toute la longueur et, de préférence, sur toute largeur de la rainure.

De préférence, le deuxième organe thermoélectrique présente une forme d'une bande, de préférence rectiligne, dont la largeur est comprise entre 1,0 µm et 3,0 µm, par exemple égale à 2,0 µm et une longueur comprise entre 0,5 mm et 2,0 mm, par exemple est égale à 1,0 mm. Par ailleurs, l'épaisseur du deuxième organe thermoélectrique peut être comprise entre 0,5 µm et 1,5 µm, par exemple égale à 1,0 µm.

Par ailleurs, le deuxième organe thermoélectrique peut présenter une épaisseur supérieure à la profondeur de la rainure. Il peut faire saillie de la face de la couche supérieure du bicouche.

Pour sa part, le premier organe thermoélectrique peut présenter une largeur comprise entre 3,0 µm et 5,0 µm, par exemple égale à 4,0 µm et/ou la longueur du premier organe thermoélectrique peut être comprise entre 0,5 mm et 2,0 mm, par exemple est égale à 1,0 mm.

De préférence, observés selon une direction normale au support, le premier organe thermoélectrique et le deuxième organe thermoélectrique présentent chacun une forme d'une bande, curviligne ou de préférence rectiligne. En particulier, le rapport de la longueur du premier organe thermoélectrique, respectivement du deuxième organe thermoélectrique, sur la largeur du premier organe thermoélectrique, respectivement du deuxième organe thermoélectrique, peut être supérieur à 100, de préférence supérieur à 200, de préférence supérieur à 500.

Les premier et deuxième organes thermoélectriques sont de préférence disposés parallèlement l'un à l'autre, un bord long du premier organe thermoélectrique étant en regard d'un bord long du deuxième organe thermoélectrique. Ainsi, le couple thermoélectrique s'étend selon une direction longitudinale parallèle aux directions longitudinales des premier et deuxième organes thermoélectriques.

De préférence, les premier et deuxième organes thermoélectriques sont reliés électriquement entre eux en au moins une zone de connexion électrique et sont isolés électriquement l'un de l'autre en au moins une zone d'isolation électrique.

De préférence, le capteur thermoélectrique comporte un revêtement d'isolation électrique, disposé entre le premier organe thermoélectrique et le deuxième organe thermoélectrique. Le revêtement d'isolation isole électriquement les premier et deuxième organes thermoélectriques dans la zone d'isolation électrique.

Le revêtement d'isolation électrique peut être au contact du premier organe thermoélectrique et du deuxième organe thermoélectrique.

Le revêtement d'isolation électrique est en un matériau électriquement isolant qui peut être choisi dans le groupe formé par Si₃N₄, SiO₂, HfO₂, Al₂O₃ et leur mélanges. De préférence, le matériau électriquement isolant est l'alumine.

De préférence, le revêtement d'isolation électrique présente une épaisseur comprise entre 10 nm et 2000 nm.

La longueur de la zone d'isolation électrique, mesurée selon la direction d'extension du deuxième organe thermoélectrique, peut être comprise entre 0,5 mm et 2,0 mm.

Le revêtement d'isolation électrique peut recouvrir au moins partiellement, voire totalement la ou les faces de la rainure.

La zone d'isolation électrique et la zone de connexion électrique peuvent être disjointes. La zone d'isolation électrique peut être définie par la ou les faces communes aux premier et deuxième organes thermoélectriques et des zones de connexion électrique peuvent être définies par d'autres faces des premier et deuxième organes thermoélectriques. Par exemple, la zone d'isolation électrique est définie par la ou les faces de la rainure, et des zones de connexion électrique respective peuvent être définies respectivement par les faces supérieures des premier et deuxième organes thermoélectriques.

En variante, la zone d'isolation électrique et la zone de connexion électrique peuvent être connexes. Notamment, la zone d'isolation électrique peut comporter une portion des faces des premier et deuxième organes thermoélectriques en contact avec le revêtement d'isolation électrique et au moins une zone de connexion électrique peut comporter une autre portion desdites faces communes.

De préférence, la zone de connexion électrique est disposée à moins de 50 µm, voire à moins de 10 µm d'un bord longitudinal du deuxième organe thermoélectrique.

Le rapport entre la longueur d'extension de la zone de connexion électrique sur la longueur d'extension de la zone d'isolation électrique peut être compris entre 0,0001 et 0,01, lesdites longueurs étant mesurées le long de la direction longitudinale du deuxième organe thermoélectrique.

La zone de connexion électrique peut s'étendre sur une longueur comprise entre 0,5 µm et 2,5 µm.

Par ailleurs, pour assurer la liaison électrique entre le premier organe thermoélectrique et la deuxième organe thermoélectrique, le capteur thermoélectrique peut être conformé de différentes manières.

Les premier et deuxième organes thermoélectriques peuvent être en contact dans la zone de connexion électrique. De préférence, l'aire de contact entre les premier et deuxième organes thermoélectriques est définie par une partie d'une face commune aux premier et deuxième organes thermoélectriques.

En variante, le couple thermoélectrique peut comporter un connecteur un connecteur électrique reliant électriquement les premier et deuxième organes thermoélectriques qui sont distants l'un de l'autre.

En particulier, le connecteur électrique peut être un pont électriquement conducteur formé d'une ou plusieurs couches électriquement conductrices, notamment métalliques, superposées au moins partiellement au premier organe thermoélectrique et au deuxième organe thermoélectrique. De préférence, le matériau formant le pont électriquement conducteur est choisi parmi le cuivre, l'argent, le plomb, l'or, l'aluminium et leurs alliages, de préférence est l'aluminium.

Le capteur thermoélectrique peut en outre comporter un espaceur électriquement isolant, par exemple en oxyde de silicium, pris en sandwich entre le pont électriquement conducteur et les premier et deuxième organes thermoélectriques.

Le pont électriquement conducteur peut relier des faces, par exemple supérieures, des premier et deuxième organes thermoélectriques, qui sont opposées aux faces recouvertes, de préférence intégralement par le revêtement d'isolation électrique.

De préférence, afin d'augmenter le courant électrique ou la tension électrique générée lors de l'échauffement du transistor de puissance, le capteur thermoélectrique comporte plusieurs couples thermoélectriques.

Les couples thermoélectriques peuvent être connectés électriquement entre eux en parallèle ou, de préférence, en série.

Le premier organe thermoélectrique d'un des couples thermoélectriques peut être relié électriquement, dans un une zone d'interconnexion électrique, avec le deuxième organe thermoélectrique d'un des autres couples thermoélectriques.

De préférence, la zone d'interconnexion électrique ente deux couples thermoélectriques est disposée à distance de chacune des zones de connexion électriques des deux couples thermoélectriques respectifs. En particulier, la distance entre la zone d'interconnexion électrique et la zone de connexion électrique d'au moins de l'un, de préférence des deux couples thermoélectriques est supérieure à 100 µm, de préférence supérieure à 200 µm, de préférence supérieure à 500 µm. De préférence, le premier organe thermoélectrique d'un des couples thermoélectriques est relié électriquement, au moyen d'un organe d'interconnexion, avec le deuxième organe thermoélectrique d'un des autres couples thermoélectriques. L'organe d'interconnexion est de préférence métallique et relie électriquement les premier et deuxième organes thermoélectriques. De préférence, l'organe d'interconnexion présente des parties au contact des faces supérieures des premier et deuxième organes thermoélectriques et au moins une partie distante des premier et deuxième organes. Un autre espaceur en un matériau électriquement isolant, par exemple de la silice, peut être pris en sandwich entre l'autre partie de l'organe d'interconnexion et les premier et deuxième organes thermoélectriques.

Dans la zone d'interconnexion électrique, le premier organe thermoélectrique de l'un des couples thermoélectriques peut être en contact avec le deuxième organe thermoélectrique de l'autre couple thermoélectrique. En variante, le premier organe thermoélectrique de l'un des couples thermoélectriques et le deuxième organe thermoélectrique de l'autre des couples thermoélectriques peuvent être reliés électriquement par un organe d'interconnexion, par exemple tel que décrit ci-dessus.

Par ailleurs, tout ou partie du premier organe thermoélectrique d'un des couples thermoélectriques peut être distant du deuxième organe thermoélectrique d'un des autres couples thermoélectriques. En particulier, ledit premier organe thermoélectrique peut être séparé du deuxième organe thermoélectrique de l'autre couple thermoélectrique par le revêtement d'isolation électrique de l'autre couple thermoélectrique.

De préférence, les couples thermoélectriques sont alignés les uns à côté des autres selon une direction d'alignement qui est oblique, de préférence perpendiculaire, à la direction longitudinale de chaque couple thermoélectrique.

Les couples thermoélectriques peuvent être identiques les unes aux autres. En variante, ils peuvent différer les uns des autres. Par exemple, ils peuvent présenter des dimensions différentes et/ou comporter des moyens de connexion électriques des premier et deuxième organes thermoélectriques différents.

En particulier, le capteur thermoélectrique comporte la répétition régulière, de préférence périodique, selon une direction d'alignement, d'un motif élémentaire formé d'au moins un couple thermoélectrique, en particulier de deux couples thermoélectriques interconnectés électriquement.

Dans un mode de réalisation, les couples thermoélectriques sont reliés électriquement en série. Le premier organe thermoélectrique d'un des couples thermoélectriques peut être distant du premier organe thermoélectrique de chacun des autres couples thermoélectriques et le deuxième organe thermoélectrique d'un des couples thermoélectrique peut être distant du deuxième organe thermoélectrique de chacun des autres couples thermoélectriques. On évite ainsi tout court-circuit au sein du groupe de couples thermoélectriques. De préférence, le premier organe thermoélectrique de l'un des couples thermoélectriques est connecté électriquement au premier organe thermoélectrique d'au moins un des couples thermoélectriques adjacents, par l'intermédiaire du deuxième organe thermoélectrique respectif du couple thermoélectrique adjacent.

Par ailleurs, le support peut être formé de silicium.

Il peut se présenter sous la forme d'une plaque ayant une épaisseur pouvant être supérieure à 0,5 mm, par exemple de 1 mm.

Le support peut être autoporteur, c'est-à-dire qu'il peut se déformer, et notamment fléchir, sans rompre sous l'effet de son propre poids.

Par ailleurs, comme décrit ci-dessus, l'invention concerne aussi un composant électronique comportant un capteur thermoélectrique selon l'invention et une unité électronique disposée sur le support.

L'unité électronique et le capteur thermoélectrique sont de préférence distants l'un de l'autre, par exemple d'une distance de séparation comprise entre 1 µm et 500 µm. Le capteur thermoélectrique peut ainsi détecter aisément une augmentation de température de l'unité électronique, par exemple d'au moins 0,1 °C.

De préférence, l'unité électronique est multicouche.

De préférence, l'unité électronique comporte une couche de base contentant un matériau choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium.

L'unité électronique peut comporter :
- une couche de base comportant, voire constituée, par le matériau de la couche inférieure du bicouche, et
- optionnellement, une couche additionnelle au contact de la couche de base, comportant, voire constituée par le matériau de la couche supérieure du bicouche, la couche de base étant intercalée entre le support et la couche additionnelle.

De préférence, la couche de base est en nitrure de gallium et est optionnellement dopée, et la couche additionnelle est en nitrure d'aluminium gallium et est optionnellement non-dopée

De préférence, la couche inférieure du bicouche du capteur thermoélectrique et la couche de base de l'unité électronique sont déposées conjointement par un même procédé de dépôt de couche, par exemple par dépôt physique en phase vapeur ou par dépôt chimique en phase vapeur.

La couche inférieure et la couche de base peuvent être disjointes. Par exemple, elles peuvent être obtenues par un procédé de dépôt d'une couche initiale suivie par une ablation locale, pour séparer la couche initiale en la couche de base inférieure et en la couche de base.

La couche inférieure et la couche de base peuvent être reliées l'une à l'autre et former une couche commune partagée par le capteur thermoélectrique et par l'unité électronique.

La couche inférieure et la couche de base peuvent présenter une composition identique.

Une couche présente une face « inférieure » en regard du support et une face « supérieure », opposée à la face inférieure.

De préférence, la couche inférieure et la couche de base présentent des faces inférieures respectives, disposées à une même hauteur du support. Elles peuvent présenter des épaisseurs identiques.

L'unité électronique peut être choisie parmi une résistance, une capacité, une inductance, une diode et un transistor, notamment un transistor de puissance.

De préférence, l'unité électronique est un transistor de puissance.

Le transistor de puissance peut comporter un empilement multicouche de transistor. L'empilement multicouche de transistor peut comporter en succession :
- une couche de nitrure d'aluminium, par exemple d'épaisseur égale à 50 nm,
- la couche de base comportant, pour plus de 99,9 % de sa masse, du nitrure de gallium, par exemple d'épaisseur comprise entre 2 µm et 4 µm, et
- la couche additionnelle comportant, pour plus de 99,9% de sa masse, du nitrure d'aluminium-gallium, par exemple d'épaisseur comprise entre 10 nm et 40 nm.

De préférence, le capteur thermoélectrique comporte un empilement multicouche de capteur qui présente une même succession de couches que l'empilement multicouche de transistor.

Des couches de même rang au sein respectivement de l'empilement multicouche de transistor et de l'empilement multicouche de capteur présentent de préférence une même composition chimique et peuvent présenter une même épaisseur.

Avantageusement, le capteur thermoélectrique et le transistor de puissance peuvent être fabriqués par une succession d'étapes de dépôt conjointes pour former les couches d'un même rang des empilements respectifs.

Par ailleurs, le transistor de puissance peut être un transistor à effet de champ, dénommé transistor « FET ». De préférence, il est de type HEMT, acronyme anglais de « High Electron Mobility Transistor ».

Par ailleurs, le capteur thermoélectrique selon l'invention peut être fabriqué au moyen du procédé selon l'invention.

A l'étape a), le substrat peut comporter, voire peut être constitué par, le support.

Le substrat peut comporter en outre une couche primaire ou un empilement de couches primaires. Par exemple, la couche primaire peut être une couche de nitrure d'aluminium, dont l'épaisseur peut être comprise entre 1 nm et 100 nm, par exemple égale à 50 nm

Le premier matériau et/ou le deuxième matériau peuvent être déposés au moyen d'une technique choisie parmi le dépôt physique en phase vapeur, notamment à base de précurseurs organométalliques aussi connu sous l'acronyme « MOCVD » pour « Metal Organic Chemical Vapor Déposition ».

De préférence, le premier matériau est le nitrure de gallium et le deuxième matériau est le nitrure d'aluminium gallium.

Par ailleurs, le procédé peut comporter le dépôt d'une pellicule de piégeage d'électrons, telle que décrite ci-dessus, sur le premier matériau, puis le dépôt du deuxième matériau sur la pellicule de piégeage d'électrons.

A l'étape b), la rainure peut être formée par lithographie et gravure du bicouche, la rainure étant définie par la zone gravée dans le bicouche.

Par « lithographie et gravure » d'une couche ou d'une empilement de couches, on entend une technique comportant en succession :
- une étape de dépôt d'un masque par lithographie, notamment par photolithographie, sur la face supérieure de la couche ou de l'empilement, le masque présentant au moins une portion pleine et au moins une portion évidée, et
- une étape de gravure, physique ou chimique, de la partie de la couche ou de l'empilement recouverte par la portion évidée du masque.

De préférence plusieurs rainures sont formées à l'étape b), deux rainures adjacentes étant séparées par un premier organe thermoélectrique adjacent. En particulier, les rainures peuvent être formées de manière à définir un réseau de rainures.

De préférence, les rainures s'étendent selon des directions parallèles. Elles sont de préférences formées à distance les unes des autres selon une direction oblique, de préférence perpendiculaire à leur direction d'extension. Ainsi, deux rainures consécutives sont séparées par un premier organe thermoélectrique. De préférence, deux rainures adjacentes peuvent être séparées par une distance comprise entre 0,25 µm et 5,0 µm, par exemple égale à 4,0 µm.

A l'étape c), le revêtement d'isolation électrique peut être formé en déposant un matériau électriquement isolant dans la rainure. En particulier, le revêtement d'isolation électrique peut être formé en mettant en oeuvre les étapes successives suivantes de :
i) dépôt d'un matériau électriquement isolant sur la couche supérieure du bicouche pour former une couche temporaire,
ii) formation d'un masque par lithographie et gravure de la couche temporaire, la portion pleine du masque étant au moins partiellement superposée à la rainure, et
iii) décapage du masque de lithographie.

Le matériau électriquement isolant peut être choisi parmi Al₂O₃, TiO₂, HfO₂, SiN, SiO₂ et leurs mélanges. Il est de préférence en alumine.

Le matériau électriquement isolant peut être déposé par une technique choisie parmi le dépôt chimique en phase vapeur aussi dénommé CVD, notamment le dépôt chimique en phase vapeur assisté par plasma aussi dénommé PECVD, le dépôt de couches atomiques aussi dénommé ALD.

A l'étape ii), les portions pleines du masque de lithographie peuvent recouvrir moins de 10 % du premier organe thermoélectrique adjacent à la rainure.

Selon une variante de mise en oeuvre, les portions pleines du masque peuvent recouvrir partiellement la rainure. Ainsi, en fin d'étape c), au moins une face de la rainure est partiellement exempte du revêtement d'isolation électrique. Elle peut ainsi définir une zone de contact électrique entre le premier organe thermoélectrique et le deuxième organe thermoélectrique formé à l'étape d).

Selon une autre variante de mise en oeuvre, les portions pleines du masque peuvent recouvrir intégralement la ou les faces de la rainure.

De préférence, selon la variante où plusieurs rainures sont formées, le procédé comporte la formation de plusieurs revêtements d'isolation électrique recouvrant chacun au moins partiellement la ou les faces d'une des rainures correspondantes. En particulier, à l'étape ii), le masque peut comporter plusieurs portions pleines, chacune étant au moins partiellement superposée à l'une des rainures correspondantes.

A l'étape d), une couche d'insertion est formée qui est au moins en partie au contact avec le revêtement d'isolation électrique.

La couche d'insertion peut être formée en déposant un troisième matériau dans la rainure.

En particulier, le troisième matériau peut être déposé sur le revêtement d'isolation électrique et, le cas échéant sur la ou les faces de la rainure définies par le bicouche.

En particulier, la couche d'insertion peut être formée en mettant en oeuvre les étapes successives suivantes de :
i') dépôt d'un troisième matériau sur la couche supérieure du bicouche ainsi que sur le revêtement d'isolation électrique, pour former une autre couche temporaire,
ii') formation d'un autre masque par lithographie et gravure de l'autre couche temporaire, la portion pleine de l'autre masque étant superposée au moins partiellement, voire totalement au revêtement d'isolation, et
iii') décapage de l'autre masque de lithographie.

De préférence, le troisième matériau est un métal thermoélectrique, par exemple l'aluminium.

De préférence, la portion pleine de l'autre masque superposée à la rainure présente, en vue de dessus, une forme d'une bande, de préférence rectiligne.

En variante, le troisième matériau peut être en un matériau semi-conducteur choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium et leurs mélanges. De préférence, le troisième matériau est le nitrure de gallium ou le nitrure d'aluminium-gallium. Le procédé comporte alors le dopage de la couche d'insertion au moyen d'un élément dopant choisi pour que la couche d'insertion soit dopée p, par exemple le magnésium.

Ainsi, la couche d'insertion définit un deuxième organe thermoélectrique.

Le procédé peut comporter la formation et, optionnellement le dopage, de plusieurs couches d'insertion, chacune contenue dans une des rainures correspondantes.

Ainsi, les couches d'insertion définissent avec des zones adjacentes de part et d'autre du bicouche plusieurs couples thermoélectriques.

En particulier, à l'étape ii'), l'autre masque peut comporter plusieurs portions pleines, chacune étant au moins partiellement, voire totalement, superposée à l'une des rainures correspondantes.

De préférence, les couches d'insertion sont formées à distance les unes des autres. En particulier, les couches d'insertion peuvent former un réseau, de préférence sensiblement homothétique du réseau de rainures, deux couches d'insertion consécutives étant séparées par une portion du bicouche.

Ainsi, en fin d'étape d), le capteur thermoélectrique peut comporter une pluralité de premiers et deuxièmes organes thermoélectriques, qui de préférence, sont disposés en alternance les uns à côtés des autres.

Par ailleurs, selon la variante où le revêtement d'isolation électrique formé en fin d'étape c) recouvre seulement partiellement la ou les faces de la rainure, le procédé peut comprendre le dépôt du troisième matériau au contact du bicouche dans la portion de la rainure non recouverte par le revêtement d'isolation électrique. Ainsi, en fin d'étape d), les premier et deuxième organes thermoélectriques sont en contact l'un de l'autre sur une portion de leur longueur, et sont reliés électriquement. Ils sont en outre isolés électriquement l'un de l'autre par le revêtement d'isolation électrique dans la portion où le deuxième organe thermoélectrique recouvre le revêtement d'isolation électrique. Un couple thermoélectrique du capteur thermoélectrique est ainsi formé.

Par ailleurs, dans la variante où le revêtement d'isolation électrique formé en fin d'étape c) recouvre intégralement la ou les faces de la rainure, le procédé comporte de préférence une étape de formation d'un connecteur électrique reliant électriquement les premier et deuxième organes thermoélectriques. Un couple thermoélectrique du capteur thermoélectrique est ainsi formé.

Plus spécifiquement, le procédé peut comporter la formation d'un espaceur, en un matériau électriquement isolant, par exemple de la silice, superposé aux premier et deuxième organes thermoélectriques, suivie par la formation d'un pont électriquement conducteur reliant électriquement les premier et deuxième organes thermoélectriques et se superposant à l'espaceur.

Dans la variante où plusieurs premiers et deuxièmes organes thermoélectriques sont définis, le procédé peut comporter la formation de plusieurs ponts électriquement conducteurs reliant les premier et deuxièmes organes thermoélectriques correspondants. Une pluralité de couples thermoélectriques sont ainsi formés.

En particulier, le pont électriquement conducteur peut être formé sur les faces supérieures respectives des premier et deuxième organes thermoélectriques.

Par ailleurs, le procédé comporte de préférence la formation d'au moins un organe d'interconnexion pour relier électriquement deux couples thermoélectriques.

Plus spécifiquement, le procédé peut comporter la formation d'un autre espaceur, formé d'un matériau électriquement isolant, par exemple de la silice, superposé au premier organe thermoélectrique de l'un des couples thermoélectrique et au deuxième organe thermoélectrique de l'autre couple thermoélectrique, suivie par la formation de l'organe d'interconnexion qui se superpose à l'autre espaceur, et qui relie électriquement le premier organe thermoélectrique de l'un des couples thermoélectrique au deuxième organe thermoélectrique de l'autre couple thermoélectrique. Une interconnexion électrique entre les couples thermoélectriques est ainsi formée.

En variante, à l'étape d), une portion de la rainure destinée à former le deuxième organe thermoélectrique d'un couple thermoélectrique peut être exempte de revêtement et à l'étape c), on dépose la couche d'insertion au contact de l'organe thermoélectrique du couple thermoélectrique adjacent.

Par ailleurs, le procédé peut comporter, conjointement à la formation de la couche électriquement isolante du capteur thermoélectrique, la formation d'une couche électriquement isolante du transistor qui peut être faite du même matériau que la couche électriquement isolante capteur thermoélectrique.

Par ailleurs, le procédé peut comporter la fabrication de l'unité électronique, de préférence d'un transistor de puissance, d'un composant électronique selon l'invention.

Notamment, le procédé peut comporter, de préférence conjointement à la formation de la couche inférieure du capteur thermoélectrique, le dépôt du premier matériau pour former la couche de base de l'unité électronique.

La couche de base et la couche inférieure peuvent être contigües et former un ensemble monolithique. En variante, le procédé peut comporter le dépôt du premier matériau pour former une couche primaire, puis l'ablation d'une partie de la couche primaire pour séparer la couche primaire en deux parties distinctes, définissant respectivement la couche de base et la couche inférieure.

L'ablation de la pré-couche peut être effectuée par lithographie et gravure.

L'épaisseur de la couche de base et l'épaisseur de la couche inférieure sont de préférence égales, par exemple comprise entre 2 µm et 4 µm.

De préférence, la couche de base et la couche inférieure présentent des faces inférieures respectives, disposées à une même hauteur du support. Elles peuvent présenter des épaisseurs identiques.

Le procédé peut en outre comporter le dopage de la couche de base. Le dopage peut être mis en oeuvre par dopage *in-situ* lors de la croissance ou par implantation ionique d'un élément dopant à travers la face supérieure de la couche de base.

Par ailleurs, le procédé peut comporter, de préférence conjointement à la formation de la couche supérieure du bicouche du capteur thermoélectrique, le dépôt du deuxième matériau pour former la couche additionnelle de l'unité électronique.

Le procédé peut comporter le dopage de la couche additionnelle.

La couche additionnelle du capteur thermoélectrique et la couche additionnelle du transistor peuvent présenter des faces inférieures disposées à une même hauteur par rapport au support.

L'invention pourra être mieux comprise à la lecture de la description détaillée qui va suivre et des exemples et au moyen du dessin annexé dans lequel :
[Fig 1] la figure 1 illustre, selon une vue en coupe transversale, une étape du procédé de fabrication d'un capteur thermoélectrique selon l'invention selon un premier exemple de mise en oeuvre,
[Fig 2] la figure 2 illustre, selon une vue en coupe transversale, une autre étape du procédé selon le premier exemple de mise en oeuvre,
[Fig 3] la figure 3 illustre, selon une vue en coupe transversale, une autre étape du procédé selon le premier exemple de mise en oeuvre,
[Fig 4] la figure 4 illustre, selon une vue en coupe transversale, une autre étape du procédé selon le premier exemple de mise en oeuvre,
[Fig 5a] la figure 5a illustre, selon une vue en coupe transversale, une autre étape du procédé selon le premier exemple de mise en oeuvre,
[Fig 5b] la figure 5b illustre, selon une vue de dessus, l'étape du procédé illustrée sur la figure 5a,
[Fig 6] la figure 6 illustre, selon une vue en coupe transversale, une autre étape du procédé selon le premier exemple de mise en oeuvre,
[Fig 7a] la figure 7a illustre, selon une vue en coupe transversale, une autre étape du procédé selon le premier exemple de mise en oeuvre,
[Fig 7b] la figure 7b illustre, selon une vue de dessus, l'étape du procédé illustrée sur la figure 7 a,
[Fig 8] la figure 8 illustre, selon une vue en coupe transversale, une autre étape du procédé selon le premier exemple de mise en oeuvre,
[Fig 9a] la figure 9a illustre, selon une vue en coupe transversale, une autre étape du procédé selon le premier exemple de mise en oeuvre,
[Fig 9b] la figure 9b illustre, selon une vue de dessus, l'étape du procédé illustrée sur la figure 9a,
[Fig 10] la figure 10 illustre, selon une vue en coupe transversale, une autre étape du procédé selon le premier exemple de mise en oeuvre,
[Fig 11a] la figure 11a illustre, selon une vue en coupe transversale, une autre étape du procédé selon le premier exemple de mise en oeuvre,
[Fig 11b] la figure 11b illustre, selon une vue de dessus, l'étape du procédé illustrée sur la figure 11a,
[Fig 12a] la figure 12a illustre, selon une vue en coupe transversale selon le plan de coupe (II), une autre étape du procédé selon le premier exemple de mise en oeuvre,
[Fig 12b] la figure 12b illustre, selon une vue de dessus, l'étape du procédé illustrée sur la figure 12a,
[Fig 13a] la figure 13a illustre, selon une vue en coupe transversale, une autre étape du procédé selon le premier exemple de mise en oeuvre,
[Fig 13b] la figure 13b illustre, selon une vue de dessus, l'étape du procédé illustrée sur la figure 13a, et
[Fig 14] la figure 14 illustre, selon une vue en coupe transversale, un composant électronique selon l'invention fabriqué selon le premier exemple de mise en oeuvre,
[Fig 15] la figure 15 illustre, selon une vue de dessus, une étape du procédé selon un deuxième exemple de mise en oeuvre,
[Fig 16] la figure 16 illustre, selon une vue en coupe transversale selon le plan de coupe (AA), l'étape du procédé illustrée sur la figure 15, et
[Fig 17] la figure 17 illustre, selon une vue en coupe transversale selon le plan de coupe (CC), l'étape du procédé illustrée sur la figure 15.

Par souci de clarté du dessin, les proportions des différents éléments constitutif des composants électroniques illustrés ne sont pas représentés à l'échelle.

### Exemple 1

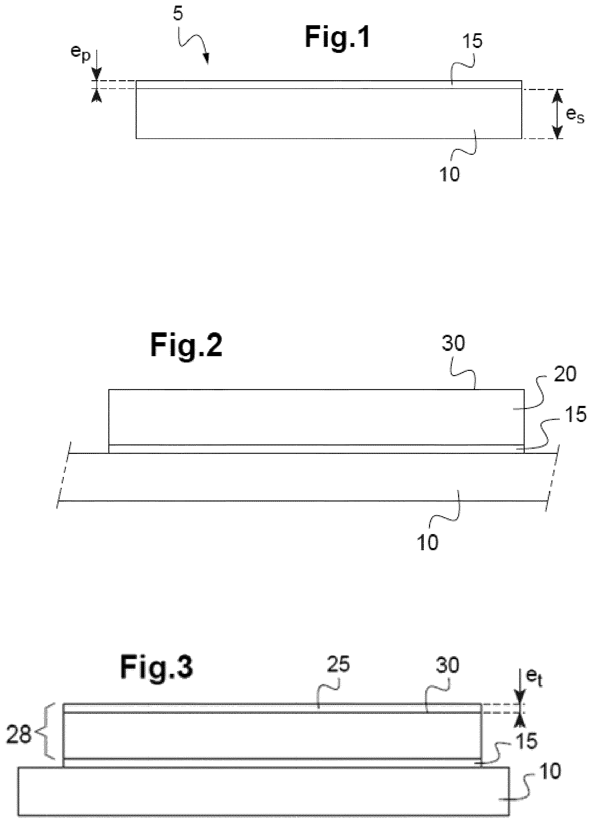

On a représenté sur les figures 1 à 14 un premier exemple de mise en oeuvre du procédé selon l'invention pour fabriquer un exemple de capteur thermoélectrique selon l'invention.

A l'étape a), comme illustré sur la figure 1, on dispose d'un substrat 5 qui comporte un support 10 en silicium et une couche primaire 15 en nitrure d'aluminium, qui recouvre le substrat. Par exemple, l'épaisseur du support eₛ est égale à 1,0 mm et l'épaisseur de la couche primaire eₚ de nitrure d'aluminium est égale à 50 nm.

Une couche 20 de nitrure de gallium est ensuite formée, par exemple par dépôt physique en phase vapeur ou par dépôt chimique en phase vapeur au contact de la couche primaire de nitrure d'aluminium.

Une couche 25 de nitrure d'aluminium-gallium est ensuite déposée au contact de la face supérieure 30 de la couche de nitrure de gallium, comme illustré sur la figure 3, par exemple par dépôt physique en phase vapeur ou par dépôt chimique en phase vapeur. La couche 25 de nitrure d'aluminium-gallium recouvre de préférence entièrement la face supérieure de la couche de nitrure de gallium. En variante, préalablement au dépôt de la couche 25 de nitrure d'aluminium-gallium, une mince pellicule de piégeage d'électrons, d'une épaisseur par exemple de 0,7 nm et faite de nitrure d'aluminium, peut être déposée sur la couche 20 de nitrure de gallium. La couche de piégeage est ainsi prise en sandwich entre la couche 20 de nitrure de gallium et la couche 25 de nitrure d'aluminium-gallium.

Un bicouche 28 est ainsi formé, comportant une couche 20 inférieure en nitrure de gallium et une couche supérieure 25 en nitrure d'aluminium-gallium.

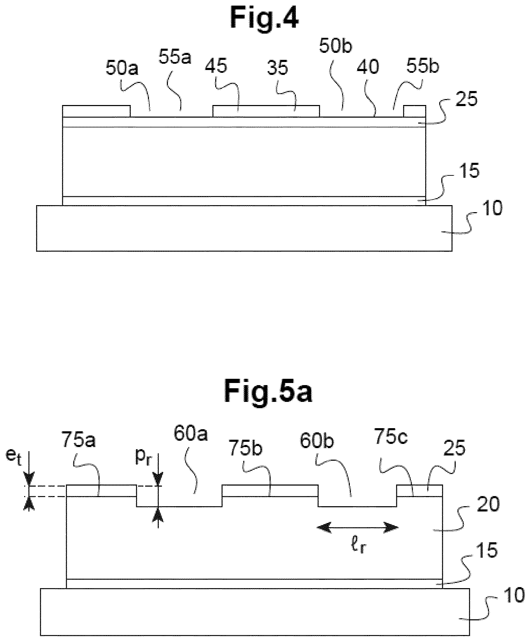

Comme cela est illustré sur la figure 4, à l'étape b), des rainures sont formées dans le bicouche. Un masque 35 est formé par photolithographie sur la face supérieure 40 de la couche supérieure de nitrure d'aluminium. Il comporte au moins une portion pleine 45, constituée par exemple d'une résine thermosensible, et des évidements 50a-b se superposant à des portions 55a-b de la face supérieure 40 de la couche supérieure de nitrure d'aluminium.

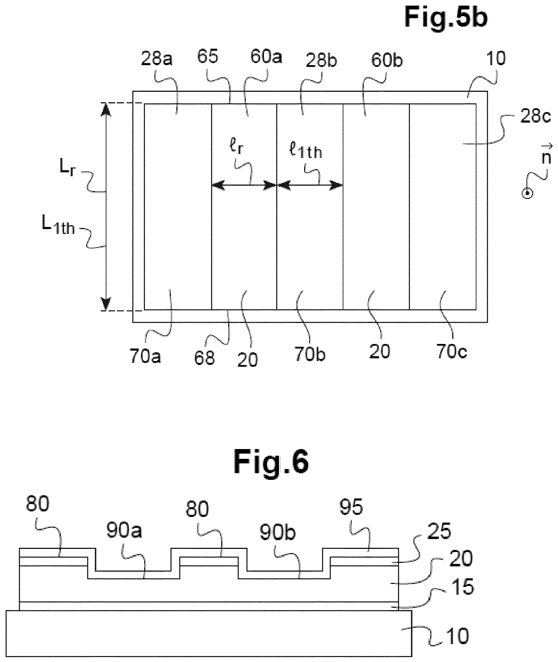

La couche supérieure de nitrure d'aluminium-gallium et la couche inférieure de nitrure de gallium sont ensuite gravées dans les portions 55a-b non recouvertes par les portions pleines du masque. Les conditions de gravure sont adaptées de telle sorte que les portions 55a-b de la couche supérieure soient intégralement retirées et que du nitrure de gallium soit retiré des portions de la couche inférieure superposées aux portions 55a-b. Le masque est ensuite retiré par décapage. Comme illustré sur les figures 5a et 5b, des rainures 60a-b sont ainsi formées, dont les profondeurs respectives pᵣ sont supérieures à l'épaisseur et de la couche supérieure 25. Les rainures présentent chacune une forme d'une bande, vue selon une direction normale n au support, qui s'étend sur toute la longueur de la couche inférieure entre deux de ses bords 65, 68 opposés l'un à l'autre.

Ainsi, des premiers organes thermoélectriques 70a-c de couples thermoélectriques en formation sont créés, qui comportent respectivement des parties 28a, 28b et 28c du bicouche 28.

Ils présentent chacun, vus selon une direction normale n au support, une forme d'une bande, et s'étendent parallèlement aux rainures 60a-b adjacentes.

Les premiers organes thermoélectriques 70a-c sont ainsi distants et isolés électriquement les uns des autres, les rainures présentant des profondeurs pᵣ supérieures à l'épaisseur et de la couche supérieure, et s'étendant de part en part entre les bords 65 et 68. Ainsi, les interfaces 75a-c entre la couche inférieure et la couche supérieure de chaque portion 28a-c respective du bicouche 28, au niveau desquelles peuvent se former de se déplacer un gaz d'électrons, sont isolées électriquement les unes des autres.

Dans l'exemple illustré, chaque rainure présente une longueur Lᵣ de 1,0 mm, une largeur lᵣ de 2,06 µm et une profondeur pᵣ de 125 nm environ et chacun des premiers organes thermoélectriques présente une longueur L₁ₜₕ de 1,0 mm, identique à la longueur d'une rainure, une largeur l₁ₜₕ de 4,0 µm et une épaisseur, correspondant à l'épaisseur de la portion dopée 45, égale à 25 nm.

A l'étape c), on forme un revêtement d'isolation électrique. Un matériau électriquement isolant peut être déposé, comme illustré sur la figure 6, sur la face supérieure de la couche supérieure 25 et sur les faces de fond 90a-b respectives des rainures qui sont définies par la couche inférieure 20 de nitrure de gallium. Une couche temporaire 95 est ainsi formée. Le matériau électriquement isolant est par exemple de l'alumine et peut être déposé par dépôt de couches atomiques (ALD) ou par dépôt chimique en phase vapeur (CVD).

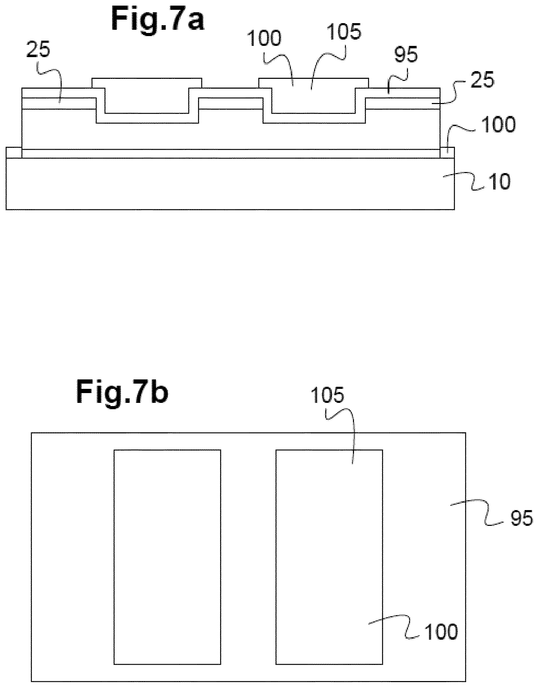

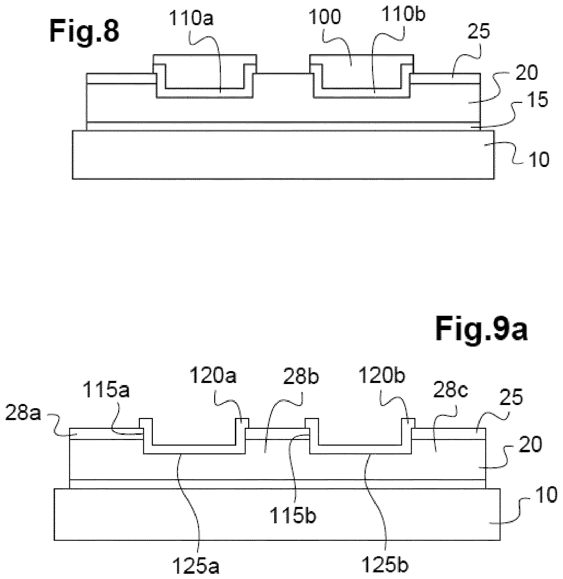

Un masque 100 est ensuite généré par photolithographie, les portions pleines 105 du masque étant superposées intégralement à la rainure, comme illustré sur les figures 7a et 7b. La couche temporaire est ensuite gravée dans sa ou ses parties non recouvertes par les portions pleines du masque, comme illustré sur la figure 8. Après décapage des portions pleines du masque, des revêtements d'isolation électrique 110a-b sont formés, chacun recouvrant entièrement les faces latérales 115a-b,120a-b et la face de fond 125a-b de chacune des rainures. Ainsi, chaque revêtement d'isolation électrique s'étend selon toute la largeur et sur toute la longueur de la rainure qu'il recouvre.

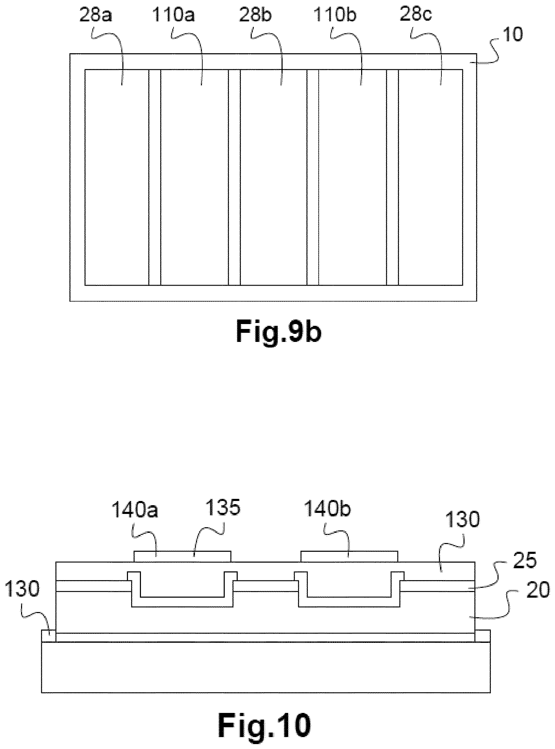

A l'étape d), dans l'exemple illustré, on dépose un troisième matériau, par exemple un métal thermoélectrique, en particulier de l'aluminium, sur la face supérieure du bicouche et sur le revêtement d'isolation électrique, de manière à former une autre couche temporaire 130. Un autre masque 135 est ensuite formé par photolithographie, dont les portions pleines 140a-b recouvrent intégralement la rainure, comme illustré sur la figure 10.

Après gravure de l'autre couche temporaire et décapage de l'autre masque, des couches d'insertion 150a-b sont formées qui remplissent chacune entièrement une rainure correspondante. Chaque couche d'insertion fait saillie du bicouche 28. Par ailleurs, les couches d'insertion étant formées en un matériau thermoélectrique, elles définissent chacune des deuxièmes organes 155a-b thermoélectriques destinés à former, avec des premiers organes thermoélectriques correspondants, des couples thermoélectriques 300a-b.

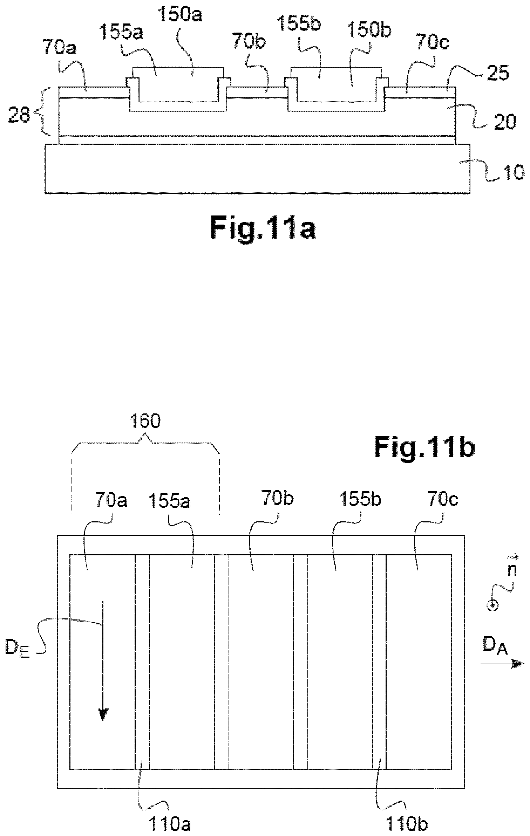

Chaque deuxième organe thermoélectrique est ainsi contigu à un premier organe thermoélectrique. Le revêtement d'isolation électrique 110a-b forme une barrière entre un premier organe thermoélectrique et un deuxième organe thermoélectrique adjacent, qui sont ainsi isolés électriquement l'un de l'autre, comme illustré sur les figures 11a et 11b.

Par ailleurs, observés selon la direction n normale au support, les premier et deuxième organes thermoélectriques s'étendent chacun selon des directions d'extension D_{E} parallèles les unes aux autres, et sont alignés côte à côte en alternance selon une direction d'alignement D_{A} perpendiculaire à la direction d'extension D_{E}. Deux premier et deuxième organes thermoélectriques adjacents forment ainsi un motif 160 qui est répété régulièrement selon la direction d'alignement D_{A}.

Dans une variante non illustrée, le troisième matériau peut être un semi-conducteur et le procédé peut comporter le dopage de la couche d'insertion pour lui conférer des propriétés thermoélectriques. Dans l'exemple illustré, la couche d'insertion peut être en nitrure de gallium ou en nitrure d'aluminium gallium et être dopée p en implantant du magnésium.

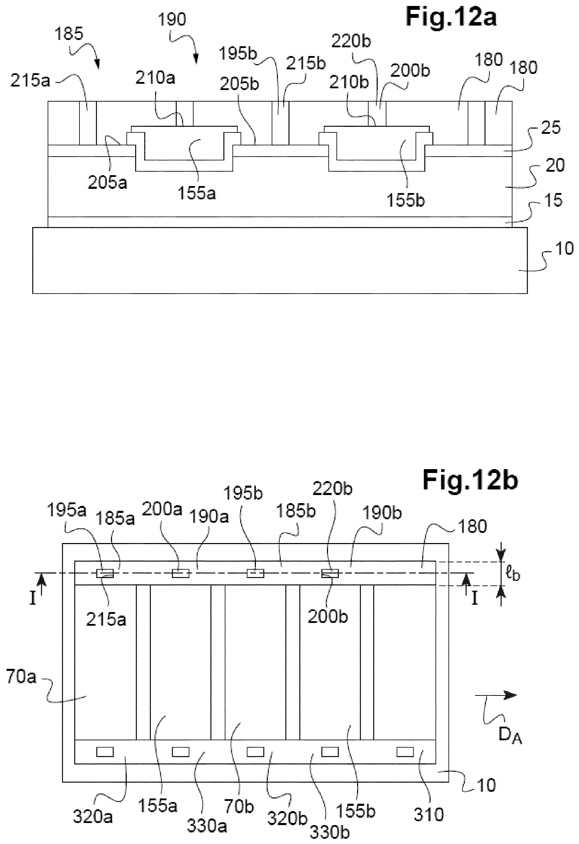

Comme décrit ci-dessus, dans l'exemple illustré, en fin d'étape d), les premiers organes thermoélectriques sont isolés électriquement des deuxièmes organes thermoélectriques par l'intermédiaire du revêtement d'isolation électrique 110a-b. Afin de former des couples thermoélectriques aptes à générer un effet Seebeck, le procédé mis en oeuvre à l'exemple 1 comporte le dépôt d'une première couche en silice 180 qui recouvre à la fois les parties 185a-b, 190a-b d'extrémité longitudinale des premiers organes thermoélectriques et des deuxièmes organes thermoélectriques respectivement. Comme illustré sur les figures 12a et 12b, la première couche de silice s'étend de part en part sur la couche supérieure 25 et sur les couches d'insertion, selon la direction d'alignement D_{A}. Vue selon la direction normale au support, la première couche de silice présente ainsi une forme d'une bande rectiligne dont la largeur l_{b} est par exemple égale à 5,5 µm. En outre, la première couche de silice comporte des première 195a-b et deuxième 200a-b fenêtres la traversant dans son épaisseur de part en part et qui débouchent sur la face supérieure 205a-b du premier organe thermoélectrique et sur la face supérieure 210a-b du deuxième organe thermoélectrique respectivement. En outre, le procédé comporte la formation de premier 215a-b et deuxième 220a-b plots électriquement conducteurs, par exemple métalliques, et en particulier en aluminium, qui sont logés dans les fenêtres. Les fenêtres ainsi que les plots électriquement conducteurs peuvent être formés successivement, par une technique de lithographie et gravure telle que décrite dans la présente description par ailleurs.

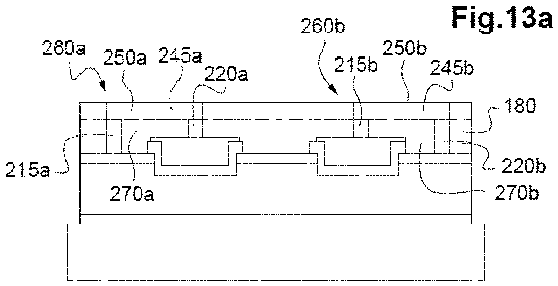

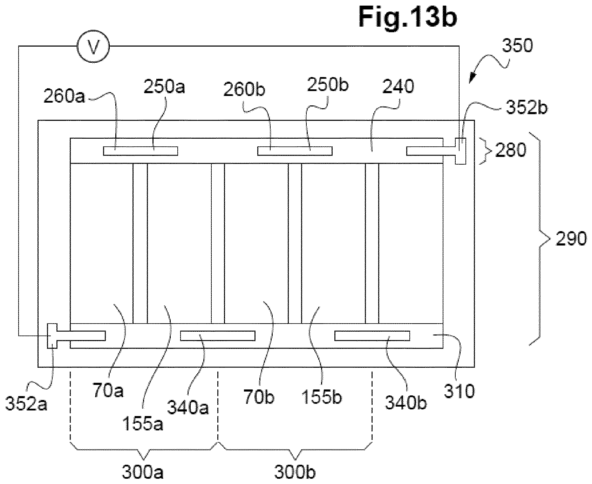

Enfin, le procédé mis en oeuvre à l'exemple 1 comporte, comme illustré sur les figures 13a et 13b la formation d'une deuxième couche de silice 240 qui est superposée intégralement à la première couche de silice 180 et *vice versa.* La deuxième couche comporte une autre fenêtre 245a-b qui la traverse de part en part dans son épaisseur et qui débouche sur les premier 220a-b et deuxième 225a-b plots électriquement conducteurs. L'autre fenêtre est par ailleurs superposée à la première couche de silice 180 et à un premier organe thermoélectrique 70a-b et à un deuxième organe thermoélectrique adjacent. Une bande 250a-b électriquement conductrice, par exemple en aluminium, est logée dans la fenêtre et est au contact des premier et deuxième plots électriquement conducteurs. Ainsi, les plots et la bande électriquement conducteurs définissent un pont 260a-b électriquement conducteur qui relie des premier 70a-b et deuxième 155a-b organes thermoélectriques adjacents. Par ailleurs, la portion de la première couche de silice prise en sandwich entre le pont électriquement conducteur et les organes thermoélectriques, est un espaceur électriquement isolant 270a-b.

Les premier et deuxième organes thermoélectriques sont ainsi connectés électriquement dans une zone de connexion électrique 280 s'étendant sur la portion d'extrémité longitudinale sur une longueur inférieure à la largeur l_{b} de la bande de silice, et sont isolés électriquement l'un de l'autre sur une zone d'isolation électrique 290 qui s'étend sur la longueur de la rainure. Des couples thermoélectriques 300a-b sont ainsi crées, qui comporte chacun des premier 70a-b et deuxième 155a-b organes thermoélectriques reliés par le pont électriquement conducteur 260a-b respectivement, qui sous l'effet de l'échauffement du transistor est apte à générer un courant électrique par effet Seebeck.

Pour augmenter la tension générée par le capteur, les couples thermoélectriques peuvent être interconnectés en série les uns aux autres. Conjointement à la formation de la première couche de silice 180, le procédé comporte la formation d'une autre couche de silice 310 qui recouvre les parties 320a-b, 330a-b d'extrémité longitudinale des premiers organes thermoélectriques et des deuxièmes organes thermoélectriques respectivement, à l'opposé de la première couche de silice 180. Des organes d'interconnexion 340a-b reliant le deuxième organe thermoélectrique, par exemple 155a d'un couple thermoélectrique, par exemple 300a, au premier organe thermoélectrique, par exemple 70b, d'un couple thermoélectrique adjacent, par exemple 300b, sont formés, selon un procédé identique à celui décrit ci-dessus pour générer les ponts électriquement conducteurs.

Un capteur thermoélectrique 350, formé de couples thermoélectriques reliés électriquement en série est ainsi obtenu au moyen du procédé mis en oeuvre à l'exemple 1.

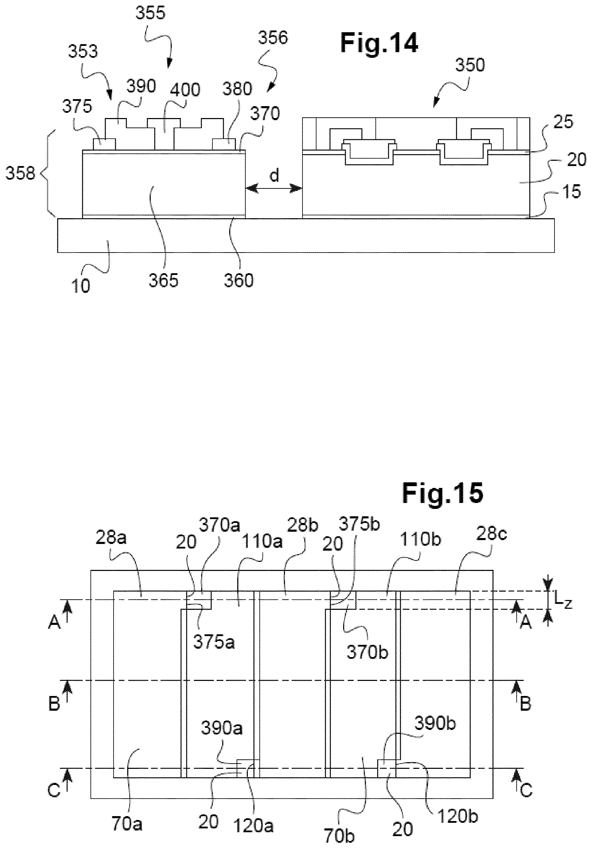

Il peut être relié à un voltmètre ou à un ampèremètre, par l'intermédiaire de pâtes de connexion 352a-b déposées sur le support et auxquelles il est relié, pour mesurer la tension électrique ou le courant électrique généré respectivement par une unité électronique 353, disposée sur le support à proximité, comme illustré sur la figure 14. Par exemple, la distance de séparation d séparant l'unité électronique et le capteur thermoélectrique peut être comprise entre 1 µm et 500 µm.

La figure 14 illustre un composant électronique 356 comportant un capteur thermoélectrique et une unité électronique 353 disposée sur le support.

L'unité électronique est par exemple un transistor de puissance 355. Il comporte, comme le capteur thermoélectrique 350, un empilement 358 formé consécutivement et en contact les unes sur les autres :
- d'une couche primaire 360 en nitrure d'aluminium,
- d'une couche de base 365 en nitrure de gallium, et
- d'une couche additionnelle 370 en nitrure d'aluminium gallium.

Les couches primaires 15 et 360 présentent de préférence une même épaisseur, les couche de base 365 et couche inférieure 20 présentent de préférence une même épaisseur et les couche additionnelle 370 et couche supérieure 25 présentent de préférence une même épaisseur.

Le transistor de puissance comporte outre, sur et au contact de la couche additionnelle, une couche de drain 375, une couche source 380 métallique, une couche d'isolation du transistor 390 et une couche de grille 400.

De préférence, la couche primaire du transistor, la couche de base 365 et la couche additionnelle sont formées respectivement au cours des mêmes étapes de dépôt que la couche primaire, la couche inférieure et la couche supérieure du capteur thermoélectrique respectivement.

Autrement dit, le procédé comporte la formation de la couche primaire du transistor, de la couche de base et de la couche additionnelle conjointement au dépôt de la couche primaire, la couche inférieure et la couche supérieure du capteur thermoélectrique respectivement.

Par ailleurs, la couche de drain et la couche métallique sont de préférence métalliques. Elles peuvent être formées au cours de l'opération de dépôt du troisième matériau de la couche d'insertion du capteur thermoélectrique.

### Exemple 2

Le capteur thermoélectrique du composant électronique de l'exemple 2, selon l'invention, diffère de celui illustré dans l'exemple 1 en ce que les premier et deuxième organes thermoélectriques d'un couple thermoélectriques sont en contact direct l'un avec l'autre dans une zone de connexion électrique 370.

Le capteur thermoélectrique peut être fabriqué en mettant en oeuvre les étapes a) et b) décrites ci-dessus pour former une rainure.

Comme illustré sur la figure 15, le procédé de fabrication diffère de celui mis en oeuvre dans l'exemple 1, en ce que l'on forme un revêtement d'isolation électrique 110a-b qui recouvre partiellement seulement les faces de la rainure. Pour former un tel revêtement, un masque est déposé sur la couche temporaire 95, qui est non superposé à une portion de la rainure dans une portion d'extrémité longitudinale 370a-b de la rainure. En particulier, dans ladite portion d'extrémité longitudinale, le revêtement d'isolation électrique 110a recouvre la partie de la rainure contiguë à une portion 28b du bicouche 28 destinée à former un premier organe thermoélectrique 70b d'un autre couple thermoélectrique adjacent. On évite ainsi la formation d'un court-circuit au sein du capteur thermoélectrique.

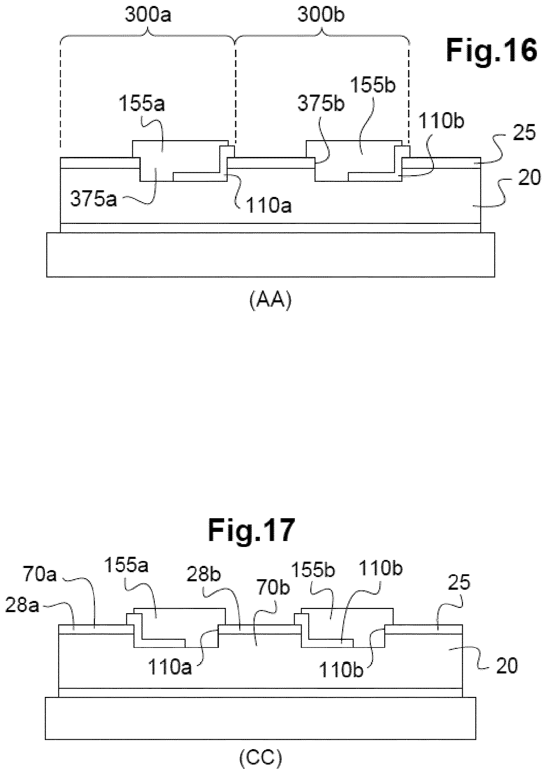

Le procédé comporte ensuite la formation d'une couche d'insertion comme décrit dans l'exemple 1, qui remplit l'intégralité du volume de la rainure. Comme illustré sur la figure 16, le deuxième organe thermoélectrique 155a-b ainsi formé est, dans la portion d'extrémité de la rainure, en contact direct avec un premier organe thermoélectrique adjacent dans une zone de connexion électrique 375a-b et isolé électriquement de l'autre premier organe thermoélectrique adjacent. La zone de contact électrique peut notamment s'étendre, sur une distance L_{z} mesurée selon la longueur de la rainure, inférieure à 10 µm. Par ailleurs, dans la zone d'isolation électrique 380a-b, où le revêtement d'isolation électrique recouvre entièrement les faces de la rainure, les premier et deuxième organes thermoélectriques sont distants les uns des autres et isolés électriquement, comme illustré déjà sur la figure 11a.

Le procédé selon le deuxième est ainsi particulièrement simple de mise en oeuvre. Le capteur thermoélectrique peut être fabriqué avec un nombre limité de couches à déposer.

Par ailleurs, afin d'interconnecter deux couples thermoélectriques adjacents, le revêtement d'isolation électrique est non superposé, dans la portion d'extrémité 390a-b opposée de la rainure, à la face de la rainure 120a-b contiguë à la portion du bicouche destiné à former un premier organe thermoélectrique d'un autre couple thermoélectrique. Ainsi, dans la zone d'interconnexion électrique comme illustré sur la figure 17, le deuxième organe thermoélectrique 155a d'un couple thermoélectrique 300a est en contact direct avec le premier organe thermoélectrique 70b du couple thermoélectrique 300b adjacent. Les couples thermoélectriques adjacents sont ainsi reliés en série.

## Revendications

1. Capteur thermoélectrique multicouche (350), pour générer un courant électrique sous l'effet d'un échauffement, le capteur thermoélectrique comportant un support (10) et un couple thermoélectrique (300a-b) porté par le support (10) et comportant :
- un premier organe thermoélectrique (70a-b) comportant au moins une portion d'un bicouche (28) dont les couches sont en des matériaux différents, et
- un deuxième organe thermoélectrique (155a-b) comportant un matériau semi-conducteur dopé p et/ou un métal thermoélectrique,
le couple thermoélectrique (300a-b) étant configuré pour générer un gaz d'électrons à l'interface (75a-b) entre les couches du bicouche (28), lors de l'échauffement du capteur thermoélectrique (350),
**caractérisé en ce que** les couches du bicouche (28) sont chacune non dopées.

2. Capteur thermoélectrique (350) selon la revendication 1, le bicouche (28) étant constitué d'une couche en nitrure de gallium et d'une couche en nitrure d'aluminium-gallium.

3. Capteur thermoélectrique (350) selon l'une quelconque des revendications précédentes, le bicouche (28) étant constitué d'une couche supérieure (25) et d'une couche inférieure (20) intercalée entre le support (10) et la couche supérieure (25), la couche inférieure (20) étant en nitrure de gallium et la couche supérieure (25) étant en nitrure d'aluminium-gallium.

4. Capteur thermoélectrique (350) selon l'une quelconque des revendications précédentes, la couche supérieure (25), et optionnellement la couche inférieure (20), du bicouche (28) et le deuxième organe thermoélectrique (155a-b) ayant des première et deuxième régions non superposées l'une sur l'autre.

5. Capteur thermoélectrique (350) selon l'une quelconque des revendications précédentes, le deuxième organe thermoélectrique (155a-b) étant logé au moins en partie dans une rainure (60a-b) ménagée dans le bicouche (28).

6. Capteur thermoélectrique (350) selon la revendication précédente, le bicouche (28) consistant en une couche supérieure (25) et en une couche inférieure (20) intercalée entre le support (10) et la couche supérieure (25), la rainure (60a-b) traversant la couche supérieure (25) de part en part selon l'épaisseur du bicouche (28), et s'étendant dans la couche inférieure (20).

7. Capteur thermoélectrique (350) selon la revendication précédente, la rainure (60a-b) traversant le bicouche (28) de part en part selon l'épaisseur du bicouche (28).

8. Capteur thermoélectrique (350) selon l'une quelconque des revendications précédentes, le capteur thermoélectrique comportant un revêtement d'isolation électrique (110a-b) en un matériau électriquement isolant, par exemple en alumine, disposé entre le premier organe thermoélectrique (70a-b) et le deuxième organe thermoélectrique (155a-b).

9. Capteur thermoélectrique (350) selon l'une quelconque des revendications précédentes, les premier et deuxième organes thermoélectriques (260a-b) étant en contact dans une zone de connexion électrique (280).

10. Capteur thermoélectrique (350) selon l'une quelconque des revendications 1 à 6, le couple thermoélectrique (300a-b) comportant un connecteur électrique reliant électriquement les premier et deuxième organe thermoélectrique (260a-b) qui sont distants l'un de l'autre.

11. Composant électronique (356) comportant un capteur thermoélectrique (350) selon l'une quelconque des revendications précédentes et une unité électronique (353) disposée sur le support (10), le composant électronique (356) étant configuré pour que le capteur thermoélectrique (350) génère un courant électrique sous l'effet de l'échauffement de l'unité électronique (353).

12. Composant électronique (356) selon la revendication précédente, l'unité électronique (353) comportant une couche de base (365) contentant un matériau choisi parmi le nitrure de gallium, le nitrure d'aluminium-gallium, l'arséniure de gallium, le gallium-indium, le nitrure de gallium-indium, le nitrure d'aluminium, le nitrure d'aluminium-indium.

13. Composant électronique (356) selon l'une quelconque des revendications 11 et 12, l'unité électronique (353) comportant :
- une couche de base (365) comportant, voire constituée par le matériau de la couche inférieure du bicouche (28), et
- optionnellement, une couche additionnelle (370) au contact de la couche de base (365) comportant, voire constituée par le matériau de la couche supérieure (25) du bicouche (28), la couche de base (365) étant intercalée entre le support (10) et la couche additionnelle (370).

14. Composant électronique (356) selon la revendication 13, l'unité électronique (353) étant un transistor de puissance (355) dans lequel, de préférence, la couche de base (365) est en nitrure de gallium et est optionnellement dopée, et la couche additionnelle (370) est en nitrure d'aluminium gallium et est optionnellement non-dopée.

15. Dispositif choisi parmi un convertisseur d'énergie, un boitier de commande d'un moteur, un amplificateur de puissance hyperfréquence, le dispositif comportant un composant électronique (356) selon l'une quelconque des revendications 11 à 14.

## Patentansprüche

1. Thermoelektrischer Mehrschichtsensor (350) zur Erzeugung eines elektrischen Stroms unter der Wirkung einer Erwärmung, wobei der thermoelektrische Sensor einen Träger (10) und ein vom Träger (10) getragenes thermoelektrisches Paar (300a-b) aufweist und aufweist:
- ein erstes thermoelektrisches Organ (70a-b), das mindestens einen Abschnitt einer Doppelschicht (28) aufweist, deren Schichten aus unterschiedlichen Materialien sind, und
- ein zweites thermoelektrisches Organ (155a-b), das ein p-dotiertes Halbleitermaterial und/oder ein thermoelektrisches Metall aufweist,
wobei das thermoelektrische Paar (300a-b) konfiguriert ist, um bei der Erwärmung des thermoelektrischen Sensors (350) an der Schnittstelle (75a-b) zwischen den Schichten der Doppelschicht (28) ein Elektronengas zu erzeugen,
**dadurch gekennzeichnet, dass** die Schichten der Doppelschicht (28) jede nicht dotiert sind.

2. Thermoelektrischer Sensor (350) nach Anspruch 1, wobei die Doppelschicht (28) aus einer Schicht aus Galliumnitrid und aus einer Schicht aus Aluminiumgalliumnitrid besteht.

3. Thermoelektrischer Sensor (350) nach einem der vorhergehenden Ansprüche, wobei die Doppelschicht (28) aus einer oberen Schicht (25) und aus einer unteren Schicht (20) besteht, die zwischen den Träger (10) und die obere Schicht (25) eingefügt ist, wobei die untere Schicht (20) aus Galliumnitrid und die obere Schicht (25) aus Aluminiumgalliumnitrid ist.

4. Thermoelektrischer Sensor (350) nach einem der vorhergehenden Ansprüche, wobei die obere Schicht (25) und optional die untere Schicht (20) der Doppelschicht (28) und das zweite thermoelektrische Organ (155a-b) erste und zweite Bereiche haben, die nicht übereinander angeordnet sind.

5. Thermoelektrischer Sensor (350) nach einem der vorhergehenden Ansprüche, wobei das zweite thermoelektrische Organ (155a-b) zumindest zum Teil in einer in der Doppelschicht (28) ausgesparten Rille (60ab) untergebracht ist.

6. Thermoelektrischer Sensor (350) nach dem vorhergehenden Anspruch, wobei die Doppelschicht (28) aus einer oberen Schicht (25) und einer unteren Schicht (20) besteht, die zwischen den Träger (10) und die obere Schicht (25) eingefügt ist, wobei die Rille (60a-b) die obere Schicht (25) von einer Seite zur anderen gemäß der Dicke der Doppelschicht (28) durchquert und sich in der unteren Schicht (20) erstreckt.

7. Thermoelektrischer Sensor (350) nach dem vorhergehenden Anspruch, wobei die Rille (60a-b) die Doppelschicht (28) von einer Seite zur anderen gemäß der Dicke der Doppelschicht (28) durchquert.

8. Thermoelektrischer Sensor (350) nach einem der vorhergehenden Ansprüche, wobei der thermoelektrischer Sensor eine elektrische Isolierbeschichtung (110a-b) aus einem elektrisch isolierenden Material aufweist, zum Beispiel aus Aluminiumoxid, die zwischen dem ersten thermoelektrischen Organ (70a-b) und dem zweiten thermoelektrischen Organ (155a-b) angeordnet ist.

9. Thermoelektrischer Sensor (350) nach einem der vorhergehenden Ansprüche, wobei die ersten und zweiten thermoelektrischen Organe (260a-b) in einer elektrischen Verbindungszone (280) in Kontakt sind.

10. Thermoelektrischer Sensor (350) nach einem der Ansprüche 1 bis 6, wobei das thermoelektrische Paar (300a-b) einen elektrischen Verbinder aufweist, der die ersten und zweiten thermoelektrischen Organe (260a-b) elektrisch verbindet, die voneinander entfernt sind.

11. Elektronisches Bauteil (356), das einen thermoelektrischen Sensor (350) nach einem der vorhergehenden Ansprüche und eine auf dem Träger (10) angeordnete elektronische Einheit (353) aufweist, wobei das elektronische Bauteil (356) so konfiguriert ist, dass der thermoelektrische Sensor (350) unter der Wirkung der Erwärmung der elektronischen Einheit (353) einen elektrischen Strom erzeugt.

12. Elektronisches Bauteil (356) nach dem vorhergehenden Anspruch, wobei die elektronische Einheit (353) eine Basisschicht (365) aufweist, die ein Material enthält, das unter Galliumnitrid, Aluminiumgalliumnitrid, Galliumarsenid, Indium-Gallium, Indiumgalliumnitrid, Aluminiumnitrid, Indiumaluminiumnitrid ausgewählt wird.

13. Elektronisches Bauteil (356) nach einem der Ansprüche 11 und 12, wobei die elektronische Einheit (353) aufweist:
- eine Basisschicht (365), die das Material der unteren Schicht der Doppelschicht (28) aufweist oder sogar daraus besteht, und
- optional eine zusätzliche Schicht (370) in Kontakt mit der Basisschicht (365), die das Material der oberen Schicht (25) der Doppelschicht (28) aufweist oder sogar daraus besteht, wobei die Basisschicht (365) zwischen den Träger (10) und die zusätzliche Schicht (370) eingefügt ist.

14. Elektronisches Bauteil (356) nach Anspruch 13, wobei die elektronische Einheit (353) ein Leistungstransistor (355) ist, wobei vorzugsweise die Basisschicht (365) aus Galliumnitrid und optional dotiert ist, und die zusätzliche Schicht (370) aus Aluminiumgalliumnitrid und optional nicht-dotiert ist.

15. Vorrichtung, ausgewählt aus einem Energiewandler, einer Steuereinheit eines Motors, einem Höchstfrequenzleistungsverstärker, wobei die Vorrichtung ein elektronisches Bauteil (356) nach einem der Ansprüche 11 bis 14 aufweist.

## Claims

1. Multilayer thermoelectric sensor (350) for generating an electrical current under the effect of heating, the thermoelectric sensor comprising a carrier (10) and a thermoelectric couple (300a-b) borne by the carrier (10) and comprising:
- a first thermoelectric member (70a-b) comprising at least one portion of a bilayer (28) whose layers are of different materials, and
- a second thermoelectric member (155a-b) comprising a p-doped semiconductor material and/or a thermoelectric metal,
the thermoelectric couple (300a-b) being configured to generate an electron gas at the interface (75a-b) between the layers of the bilayer (28) during the heating of the thermoelectric sensor (350),
**characterized in that** the layers of the bilayer (28) are each undoped.

2. Thermoelectric sensor (350) according to Claim 1, the bilayer (28) consisting of a layer of gallium nitride and of a layer of aluminium-gallium nitride.

3. Thermoelectric sensor (350) according to either one of the preceding claims, the bilayer (28) consisting of an upper layer (25) and of a lower layer (20) sandwiched between the carrier (10) and the upper layer (25), the lower layer (20) being of gallium nitride and the upper layer (25) being of aluminium-gallium nitride.

4. Thermoelectric sensor (350) according to any one of the preceding claims, the upper layer (25) and, optionally, the lower layer (20) of the bilayer (28) and the second thermoelectric member (155a-b) having first and second regions not superposed onto one another.

5. Thermoelectric sensor (350) according to any one of the preceding claims, the second thermoelectric member (155a-b) being accommodated, at least in part, within a groove (60a-b) formed in the bilayer (28).

6. Thermoelectric sensor (350) according to the preceding claim, the bilayer (28) consisting of an upper layer (25) and of a lower layer (20) sandwiched between the carrier (10) and the upper layer (25), the groove (60a-b) passing right through the upper layer (25) across the thickness of the bilayer (28), and extending into the lower layer (20).

7. Thermoelectric sensor (350) according to the preceding claim, the groove (60a-b) passing right through the bilayer (28) across the thickness of the bilayer (28) .

8. Thermoelectric sensor (350) according to any one of the preceding claims, the thermoelectric sensor comprising an electrically-insulating coating (110a-b) of an electrically-insulating material, for example of alumina, disposed between the first thermoelectric member (70a-b) and the second thermoelectric member (155a-b).

9. Thermoelectric sensor (350) according to any one of the preceding claims, the first and second thermoelectric members (260a-b) being in contact within an electrical connection region (280).

10. Thermoelectric sensor (350) according to any one of Claims 1 to 6, the thermoelectric couple (300a-b) comprising an electrical connector electrically connecting the first and second thermoelectric member (260a-b) which are at a distance from one another.

11. Electronic component (356) comprising a thermoelectric sensor (350) according to any one of the preceding claims and an electronic unit (353) disposed on the carrier (10), the electronic component (356) being configured such that the thermoelectric sensor (350) generates an electrical current under the effect of the heating of the electronic unit (353).

12. Electronic component (356) according to the preceding claim, the electronic unit (353) comprising a base layer (365) containing a material chosen from amongst gallium nitride, aluminium-gallium nitride, gallium arsenide, gallium-indium, gallium-indium nitride, aluminium nitride, aluminium-indium nitride.

13. Electronic component (356) according to either one of Claims 11 and 12, the electronic unit (353) comprising:
- a base layer (365) comprising, or consisting of, the material of the lower layer of the bilayer (28), and
- optionally, an additional layer (370) in contact with the base layer (365), comprising, or consisting of, the material of the upper layer (25) of the bilayer (28), the base layer (365) being sandwiched between the carrier (10) and the additional layer (370).

14. Electronic component (356) according to Claim 13, the electronic unit (353) being a power transistor (355) in which, preferably, the base layer (365) is of gallium nitride and is optionally doped, and the additional layer (370) is of aluminium-gallium nitride and is optionally undoped.

15. Device chosen from amongst a power converter, a motor control unit, a microwave power amplifier, the device comprising an electronic component (356) according to any one of Claims 11 to 14.
